Europäisches Patentamt

(19) European Patent Office

Office européen des brevets

(11) Publication number: **0 028 097**
**A1**

(12) **EUROPEAN PATENT APPLICATION**

(21) Application number: **80303632.6**

(22) Date of filing: **15.10.80**

(51) Int. Cl.³: **B 24 B 9/00**

(30) Priority: **15.10.79 GB 7935737**

(43) Date of publication of application: **06.05.81**
**Bulletin 81/18**

(84) Designated Contracting States: **AT CH DE FR GB IT LI SE**

(71) Applicant: **EXCELLON INTERNATIONAL INCORPORATED, 23915 Garnier Street, Torrance California 90509 (US)**

(72) Inventor: **Beetlestone, Frederick Rogers M., 34 Glebelands, Pulborough, West Sussex (GB)**
Inventor: **Smith, Paul Allan, 12 Hailsham Road, Worthing, West Sussex (GB)**

(74) Representative: **Booth, Philip Charles et al, LLOYD WISE, TREGEAR & CO. Norman House 105-109 Strand, London, WC2R OAE (GB)**

(54) **Bevelling machine.**

(57) A bevelling machine for printed circuit boards having a board transport assembly (45) for passing a board between two grinding wheels (11) each mounted independently on a slide (7, 8) moved by an actuator (13) so that the wheels (11) overlap along the path of travel of a board to bevel two edges thereof at the same time. The position of at least one side of a board relative to the centre line of travel is sensed and the slide (7,8) mounting the grinding wheel which produces a bevel on the sensed side is moved to a position determined by the position of the sensing means so that the depth of cut on each side of the board is substantially the same for different thicknesses of board.

TITLE:   BEVELLING MACHINE

This invention relates to a bevelling machine for use inter alia, in bevelling contact edges of printed circuit boards.

In the production of printed circuit boards it is necessary to provide a bevel on the contacts formed on the board to prevent them lifting and provide for ease of insertion in a socket.  Various machines have been developed for this purpose but none of them, to the applicant's knowledge, is entirely satisfactory for a variety of reasons, not least of these being the inability to maintain a constant bevel angle along both edges of a board where contacts have been printed.  It is highly desirable to maintain the bevel depth and angle constant which is extremely difficult in hand-held operations and particularly for unskilled personnel.

It is an object therefore of this invention to provide a bevelling machine for printed circuit boards, particularly those made of glass reinforced plastics material, which will bevel both sides of one edge of a board at the same time and maintain a constant bevel angle.

It is a further object of this invention to provide a bevelling machine which may be used by unskilled personnel and provide accuracy of bevel depth and consistency of bevel angle at a high throughput.

In accordance with this invention therefore we provide: a bevelling machine comprising; a board transport assembly,

material removing means having independent elements to remove material from opposite edges of a board and produce a bevel thereon,

means mounting said elements one each side of a path of travel defined by said transport assembly,

actuating means to move each element in a common plane towards said path of travel, said common plane being transverse to the plane of a board transported by said transport assembly,

means sensing the position of at least one face of a board, and

means responsive to said sensing means to move the associated element relative to said board as it is transported towards said material removing means by said transport assembly.

In a preferred embodiment of the invention to be described in detail hereinafter, the material removing means comprises diamond grinding wheels each journalled in a slide mounted on a rail for movement by actuators towards a path of travel of a printed circuit board defined by the transport assembly. The height of the transport assembly is adjustable relative to the axes of the grinding wheels which lie in a common plane at right angles to the plane of a board as it travels between the grinding wheels which overlap to bevel the opposite edges of a board at the same angle.

In one preferred embodiment of the invention one of the grinding wheels is moved by said actuating means into a predetermined position relative to the centre line of travel of the board and hence to one side of the board and is then fixed in position whilst the sensing means senses the position of the opposite side of the board, actuates said actuating means to move the other grinding wheel towards the other side of the board and then maintains the other grinding wheel in a fixed position as sensed by the sensing means to maintain a constant bevel.

Preferably the grinding wheels are rotatably mounted on slides having air bearings to enable the slides to move freely along rails. The grinding wheels are fixed in position relative to the path of board travel during operation by cutting off the air supply to the bearings.

In a second embodiment ramps mounted on the slides engage wedges mounted for horizontal sliding movement on the transport assembly. Air bearings sense the position of opposite faces of that edge of a board to be bevelled relative to the centre line of board travel. Any variations in the positions of the board faces cause the air bearings to move the wedges, thereby allowing the ramp and the respective grinding wheels to take up a position at which the edges of said board are bevelled at a constant depth and angle irrespective of variations in the thickness of the board.

In order that the invention may be fully understood, preferred embodiments of the invention will now be described with reference to the accompanying drawings in which:-

Figures 1A, 1B, 1C show the top, side and rear views respectively of a bevelling machine in accordance with this invention;

Figure 2 shows the main components of the bevelling machine shown in Figure 1 with the transport assembly removed from its normal working position over the grinding mechanism;

Figure 3 is a cross-sectional view of a section of a slide and rail forming part of the grinding mechanism shown in Figure 2;

Figure 4 is a cross-sectional view of an actuator for moving a slide along a rail of the grinding mechanism shown in Figure 2;

Figure 5 is a diagrammatic view showing the positions of the grinding wheels relative to the underside of the transport assembly shown in the upper part of Figure 2;

Figure 6 is a cross-sectional view of a grinding wheel;

Figure 7 is a simplified diagram showing a printed circuit board being transported by belts of the transport assembly shown in the upper part of Figure 2;

Figure 8 is a modification of the transport assembly shown in Figure 2;

Figure 9 is a cross-sectional view of part of the modified transport assembly shown in Figure 8 taken through the knurled heads of the ramp adjusting screws shown in Figure 2;

Figure 10 shows an alternative form of actuator, and

Figure 11 shows another form of actuator.

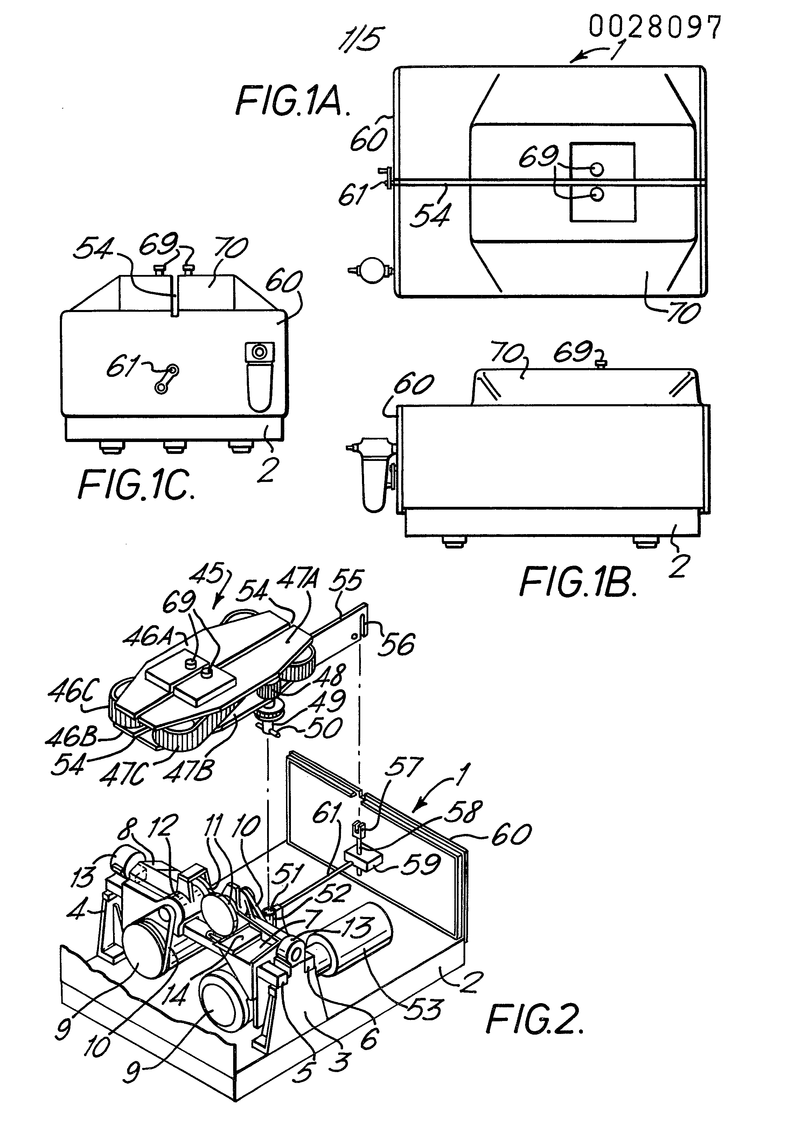

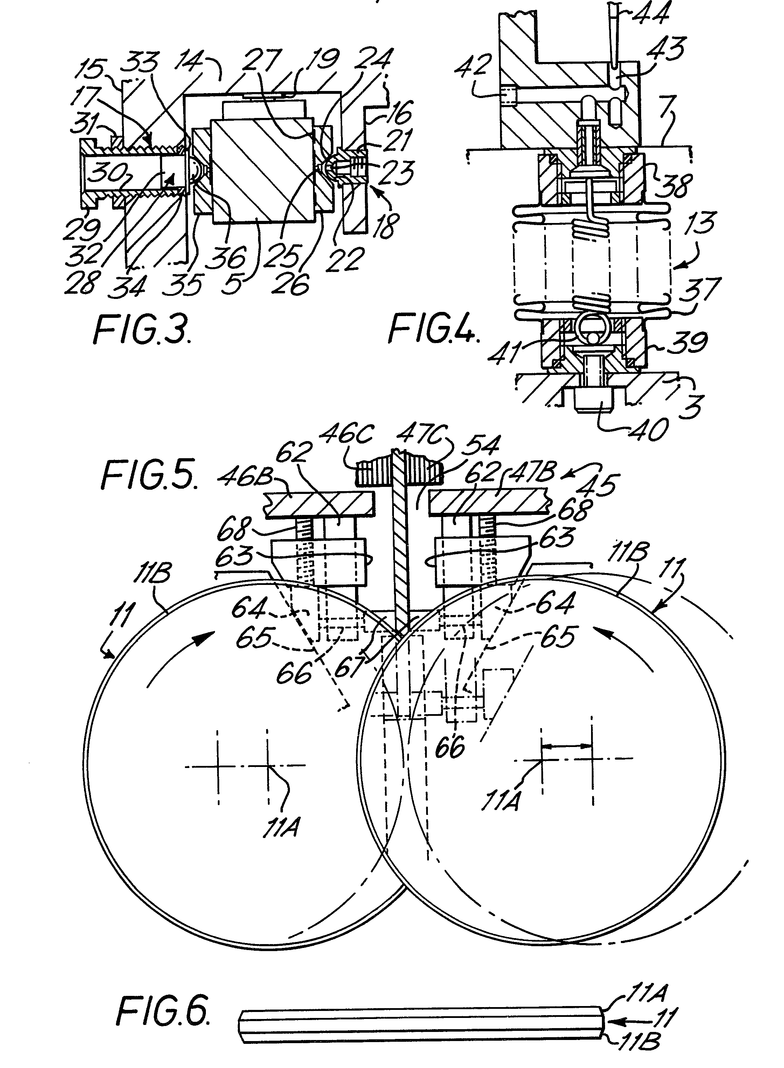

Referring now to Figures 1 and 2 of the drawings, a bevelling machine 1 comprises a heavy granite base 2 on which is mounted vertical truncated triangular plates

;5;

0028097

3 and 4 supporting guide rails 5 and 6 carrying slides 7 and 8 each supporting a motor 9 driving via a belt 10 a precision manufactured double bevelled grinding wheel 11 journalled in a bearing 12. Fixed to each plate 3 and 4 is an actuator 13 for moving the respective slide along its associated rail.

Each slide 7, 8, comprises a plate 14 straddling both rails 5 and 6 and having depending sides 15 and 16 mounting self-aligning air bearings 17 and 18 respectively. The mass of the components of each slide and the position of the motor 9 are selected so that the centre of gravity of each slide lies in the vertical central plane of the associated rail. An air bearing 19 is located in the underside of plate 14 above the associated guide rail. As shown in Figure 3, air bearing 18 includes a nozzle 21 having a domed end 22 with an aperture 23 therein. The domed end 22 engages a conical recess 24 having a central hole 25 in a disc-like self-aligning air shoe 26 with a high frictional surface 27 on one side thereof. Air bearing 19 is of the same construction as air bearing 18 but the bearing 17 has a different form of nozzle. Nozzle 28 of bearing 17 has a preload adjuster 29 in the form of a tube 30 threaded into the side 15 with a lock nut 31 to fix the position of the tube 30 therein. The nozzle 28 has a tubular portion 32 slideable fitting snugly inside the bore of tube 30, and a flange 33 with an elastomeric ring 34 located between the flange 33 and the end of the tube 30. Self-aligning air shoe 35 of bearing 17 is of the same construction as the shoe 26 and domed end 36 is of the same form as the end 22 of air bearing 18.

In operation compressed air is supplied to the air bearings 17, 18 and 19, bearing 19 lifts plate 14 off the rail 5 and air ejected from the nozzles 21 and 28 passes through the holes in the conical recesses of the respective self-aligning shoes to lift them off the sides of the rail 5 thereby enabling the slide to be floated along the rail under control of the respective actuator. The application of compressed air to air bearing 17 applies a pre-load to the elastomeric ring 34 whose initial compression is adjusted by the pre--load adjuster 29 so that on removal of air pressure the ring forces the high frictional surface of the shoe against the side of the rail thus rapidly braking the slide. A similar action occurs with the air bearing 18.

The position of each slide 7 and 8 along its respective rail is controlled by actuator 13. As shown in Figure 4 actuator 13 comprises bellows 37 secured at each end to hollow cylindrical body portions 38, 39, portion 39 being secured to the respective truncated triangular plate and having a fixing screw 40 to which is attached a spring 41 extending through the bellows 37 to be secured at the opposite end to body portion 38 which is attached to the respective slide 7 or 8. Air passageway 42 allows compressed air to be admitted to the bellows which expand and move the slide along the rail. A bleed passage 43 branching off from passage 42 is aligned with a tapered needle 44 secured to the machine frame, i.e. the base 2 or other stationary part, so that as the slide moves along the rail by expansion of the bellows against tension in the spring 41 the needle 44 enters the passage 43 increasing air pressure in the bellows which offsets the increase in the tension of spring 41. As a result the net force moving the slide forward along the rail remains approximately constant.

As will be seen from Figure 2, movement of the slides 7 and 8 along their respective guide rails 5 and 6 moves the grinding wheels 11 towards a feed path defined by a transport assembly 45 comprising pairs of plates 46A, 46B and 47A, 47B between which are toothed belts 46C, 47C, respectively. These belts are driven by sprockets (only sprocket 48 between plates 47A and 47B being shown) coupled to a shaft 49 having a rod 50 therethrough which engages a slot 51 in the end of a bifurcated spindle 52 driven by a motor 53 mounted on the base 2.

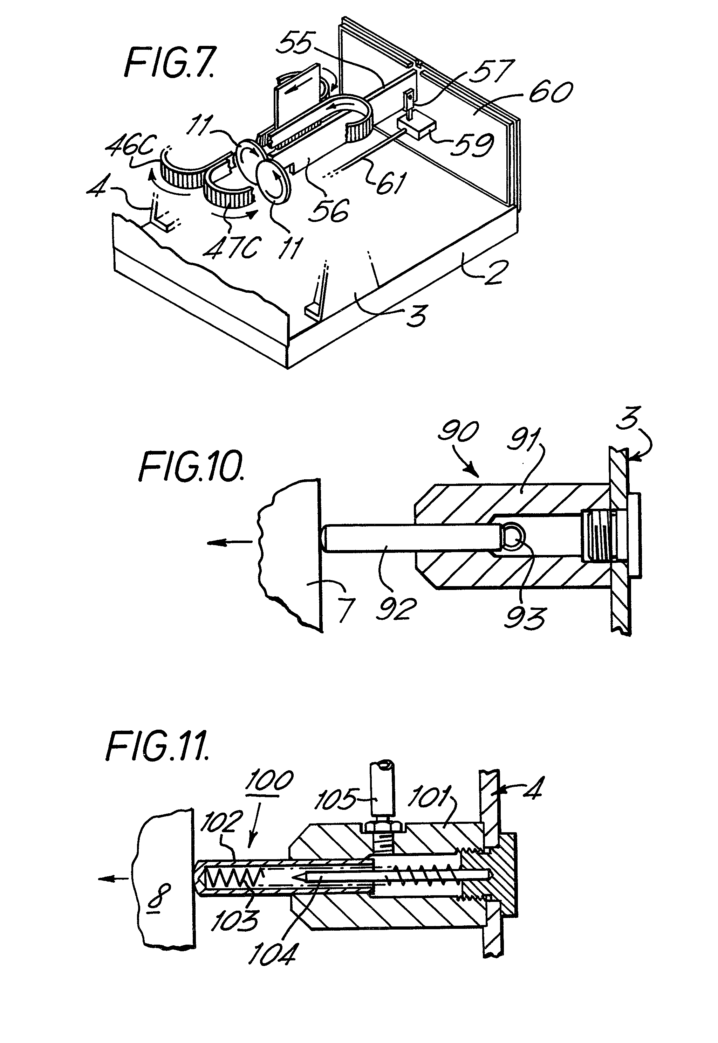

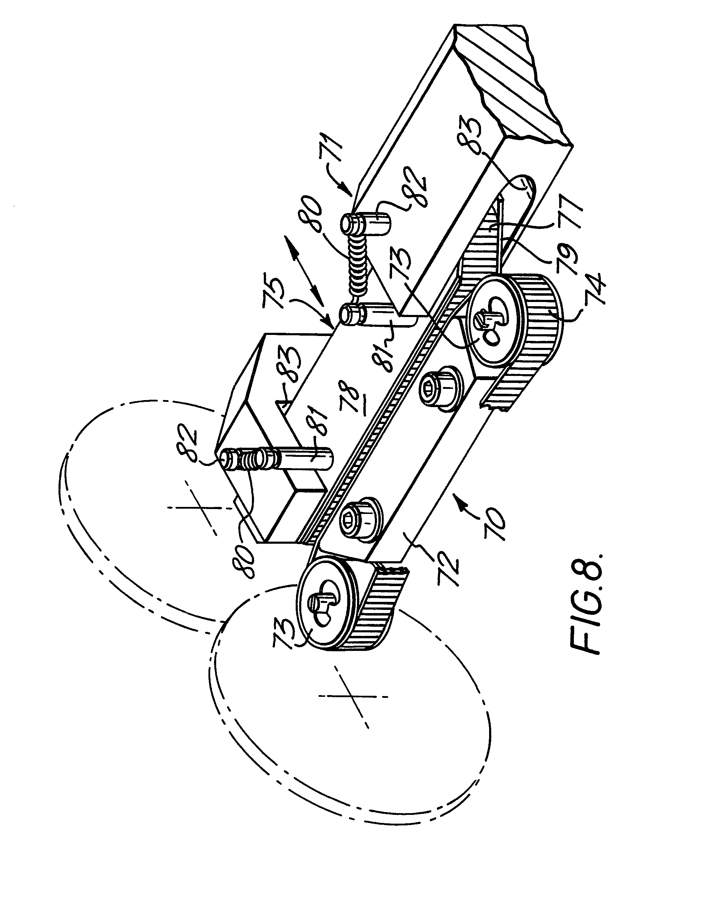

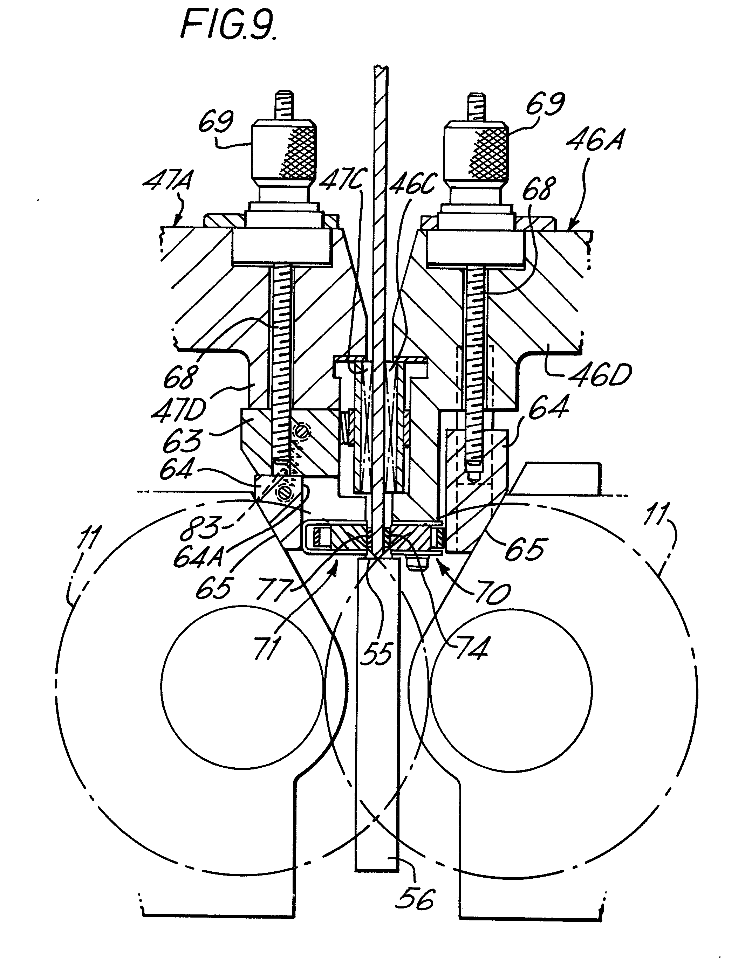

Mounted beneath the plates 46B and 47B and in line with parallel slots 54 between plates 46A, 47A and 46B, 47B, is a guide surface 55 formed by the top edge of an elongate plate 56 which extends the full length of slots 54 and projects rearwards to be engaged by a U-shaped block 57 mounted on a shaft 58 extending from a worm box 59 mounted on a rear wall 60 secured to the base 2. A worm box (not shown) similar to box 59 is mounted to the guide rail 6 at a position midway between the extremities thereof. The latter box also has a U-shaped block which supports the forward end of the elongate plate 56. The two worm boxes are coupled together by a rotatable shaft 61 which projects through the rear wall 60 with a handle attached to the projecting end. Rotation of the handle rotates shaft 61 causing both worm boxes to raise or lower the respective U-shaped blocks in unison thereby raising or lowering the transport assembly 45 parallel to the base 2 and at right angles to the plane of movement of the grinding wheels 11 rotatably supported on their respective slides 7 and 8. Each side of the slots 54 is a straight run of belt 46C, 47C which, as shown in Figure 7 together grip a printed circuit board and feed it forward towards the grinding wheels 11 with its lower edge resting on the surface 55 of elongate plate 56. Thus the slots 54 together with the straight runs of the belts define a path of movement for printed circuit boards to be bevelled which is at right angles to the grinding wheels 11 and positioned to pass boards fed along the slots 54 between the overlapping grinding wheels whose axes are in the same horizontal plane so that the boards are bevelled at an angle depending on the vertical position of the transport assembly relative to the axis of the grinding wheels as shown in Figure 5.

Figure 5 is a simplified view of the underside of the transport assembly 45 when in position in the bevelling machine and the two grinding wheels 11. Depending from each plate 46B, 47B adjacent the slot 54 at that end of the transport assembly nearest the grinding wheels 11 is a pillar 62 on which slides a block 63 having a wedge 64 slidably mounted on the underside thereof. The wedge 64 engages a ramp 65 mounted adjacent a grinding wheel on the associated slide. Extending horizontally from the wedge 64 is a dowel 66 supporting an air bearing 67 which is coupled to a source of compressed air (not shown). An adjusting screw 68 having a knurled head 69 (Figure 2) engages the block 63 to adjust its position on pillar 62.

In operation that edge of a printed circuit board having a plurality of contacts is placed on the guide surface 55 (which defines a reference plane) of plate 56 and fed into the slots 54 between the straight run of the belts 46C, 47C, which grip the board and feed it towards the grinding wheels 11.

The position of the grinding wheels 11 along the respective guide rails 5 and 6 is initially determined by the position of the wedges 64 on the ramps 65 which in turn is determined by the height of the transport assembly, and hence the reference plane provided by guide surface 55, as adjusted by the handle on shaft 61 (Figure 2) relative to the grinding wheel axes 11A which lie in a common horizontal plane. As shown in Figure 5, the bottom edge of the board on guide surface 55 is bevelled at 45$^{\mathrm{o}}$ on both sides as it is fed between the overlapping grinding wheels. During passage between the grinding wheels the air bearings 67 sense the position of the respective faces of the printed circuit board. Any variation in position of either or both sides of the board relative to the mid-plane of the path of travel of the board (i.e. any variation in thickness) results in the bearings pushing the wedges 64 away from the board and thereby the ramps and grinding wheels against the force exerted by the actuators (increase in thickness) or allowing the actuators 13 to push the grinding wheels along the rails as the wedges tend to lift off the ramps (decrease in thickness).

As shown in Figure 5, the air bearings 67 are positioned below the straight run of the belts 46C, 47C and support the bottom portion of the board projecting below the lower slot 54 as the board is fed between the grinding wheels. The air pressure supplied to the air bearings 67 is such as to produce a thin lubricating layer of air between the face of the air bearing and the opposing face of the board so that there is no contact between the opposing faces.

Since the movement of the grinding wheels 11 mounted on their respective slides 7 and 8 is in a common horizontal plane, i.e. the axes 11A remain in exactly the same vertical position relative to the guide surface 55, the depth and angle of bevel ground on the bottom edge of the printed circuit remain constant whatever the position of the opposite faces of the board relative to the mid-plane of board travel. In other words, the depth and angle of bevel are maintained constant whatever variations in board thickness are encountered. Lowering the position of the transport assembly 45, and hence guide surface 55 to the position shown in dotted lines in Figure 5 produces a bevel angle of 15$^{\circ}$.

The air bearings 67 and the structure supporting them as illustrated in Figure 5 to sense variations in thickness of a board, may be replaced by a simplified structure as shown in Figures 8 and 9 which comprises a fixed guide 70 and a movable guide 71, both secured to a structure depending from and integral with the top plates 46A, 47A of the transport assembly 45, like parts in Figures 2, 5, 8 and 9 carrying like reference numerals. The fixed guide 70 comprises a fixed slipper 72 and a pair of flanged idlers 73 around which a small tooth belt 74 is driven by movement of a board as it is transported through the assembly 45 by the belts 46C and 47C.

The fixed guide 70 is mounted to the lower end face of a structure 46D integral with the top plate 46A and depending therefrom. The wedge 64 is mounted adjacent the guide 70 on the end of the adjusting screw 68 so that the wedge 64 engages the ramp 65 of the slide 8 as its associated actuator 13 moves it toward the centre line of board travel. Preferably the wedge 64 is located mid way between the idlers 73 along the back run of the belt 74. The knurled head 69 rotates the adjusting screw 68 to lower or raise the wedge 64 to adjust the depth of cut on a board by the grinding wheel on that side of the transport assembly.

The movable guide 71 comprises an assembly 75 having a belt 77 trained around flanged idlers (not shown) journalled between upper and lower plates 78, 79 respectively. The assembly 75 is received within slots 83 at the lower end of a structure 46D integral with and depending from the top plate 47A. The assembly 75 is spring loaded by springs 80 mounted between posts 81 on the upper plate 78 and posts 82 on the lower end of structure 47D urging the assembly away from the fixed guide 70.

The wedge 64 is slidably mounted by springs 83, one each side thereof on block 63 which is secured to the lower end of screw 68 so that rotation of screw 68 raises or lowers both block 63 and wedge 64, the latter engaging ramp 65 mounted on slide 7 as the actuator 13 moves the slide and the grinding wheel rotatably mounted thereon towards the centre line of board travel. The vertical face 64A of the wedge 64 is held against the rear edges of plates 78, 79 by the springs 80 and 83.

In operation, the angle of cut is determined first by adjusting the height of surface 55 on plate 56 by means of the height adjustment comprising worm boxes 59, U-shaped blocks 57 on shaft 58 and shaft 61 (see Figure 2). Next the depth of cut is determined by the adjusting screws 68 raising or lowering the wedges 64 so that the actuators 13 move the slides 7 and 8 and the grinding wheels 11 rotatably mounted thereon to positions at which the respective ramps 65 engage the wedges 64 to fix the position of the grinding wheels relative to the centre line of board travel thereby fixing the depth of bevel cut on a board passing between the overlapping grinding wheels.

Once the correct depth of cut is obtained on both sides of a board, the position of the slide 8 on that side of the centre line of board travel at which the fixed guide 70 is located can be fixed by cutting off the air supply to the air bearings 17, 18 and 19 so that the elastomeric ring 34 brakes that slide (see Figure 3). The air supply to the other slide 7 is also cut off to fix the grinding wheel rotatably mounted thereon in a position to provide the required depth of cut on that side of the board as will now be explained.

A micro-switch (not shown) is mounted at the entrance side of the belts 74 and 77 to engage the leading edge of a board transported through the transport assembly 45 by the belts 46C, 47C and switch on the air supply to the air bearings on slide 7 and the associated actuator 13. Another micro-switch (not shown) engages the leading edge of the board just as it leaves the straight run of belts 74, 77 to switch off the air supply to both the bearings in slide 7 and its associated actuator 13 thereby braking the slide 7 and fixing the grinding wheel rotatably mounted thereon in a predetermined position relative to the centre line of board travel as determined by the position of the movable guide 71.

Thus once both grinding wheels have been set up to produce a desired depth of cut, any subsequent slight variation in board thickness is sensed by the movable guide 71 which moves the wedge 64 and hence the ramp 65 on the slide 7 towards or away from the board thereby moving the grinding wheel an amount corresponding to the amount of variation and then fixes it in that position immediately prior to the board being passed between the overlapping grinding wheels. Thus, the movable guide 71 effectively gauges the board thickness and limits the position of the movable slide and hence the associated grinding wheel accordingly.

Each grinding wheel 11 has angled edges 11A, 11B, as shown in Figure 6 and is rotated in a direction shown by the arrows in Figure 6 so that as the sides of the bottom edge of a printed circuit board are fed past the wheels the angled grinding edges progressively remove material from the board without lifting the contact material printed on the board. The precision manufactured diamond grinding wheels produce a fine ground finish and having each edge angled can be reversed when one edge becomes worn.

In the above described structure of Figure 8 it is advantageous to use simplified forms of actuator 13 since one of the slides together with its grinding wheel is fixed in position and only one slide is allowed to move relative to a board as it travels through the transport assembly 45.

An actuator 90 for the fixed slide (slide 8 in the embodiment described with reference to Figures 8 and 9) is shown in Figure 10 and comprises a cylinder 91 having a solid piston 92 therein which is actuated by air supplied through a port 93. The cylinder 91 is fixed to the plate 3 (Figure 2) and the piston 92 moves the slide 7 to a predetermined position where it is then fixed by cutting off the air supply to the air bearings 17, 18 and 19 (Figure 3).

An actuator 100 for the movable slide is shown in Figure 11 and comprises a cylinder 101 fixed to the plate 9 and having a hollow piston 102 urged outwardly therefrom by a light compression spring 103 through which passes a pin 104 to stop the spring collapsing. Air is admitted to the cylinder 101 via an air inlet port 105 to actuate the piston 102 to move the slide 8 to a position along its associated rails sensed by the movable guide 71 (Figure 8). The spring 103 prevents the end of the piston losing contact with the slide as this would allow the end of the piston to hit the slide sharply when compressed air is supplied to the cylinder.

In both actuators 90 and 100 carefully controlled clearance between the piston and cylinder provides an air bleed which acts as a bearing.

Although the actuators described above with reference to Figures 10 and 11 are primarily for use with the alternative form of transport assembly described with reference to Figures 8 and 9, either of the actuators 90 or 100, particularly actuator 90 can replace the actuator 13 used in the embodiment described with reference to Figures 1 to 7. Alternatively either or both the actuators 90 and 100 may be used in the embodiment described with reference to Figures 1 to 7.

A dust extraction device (not shown) may be positioned immediately below the grinding wheels 11 and a housing 70 provided to protect the transport mechanism 45.

CLAIMS

1. A bevelling machine comprising, a board transport assembly, material removing means having independent elements to remove material from opposite edges of a board and produce a bevel thereon, means mounting said elements one each side of a path of travel defined by said transport assembly, actuating means to move each element in a common plane towards said path of travel, said common plane being transverse to the plane of a board transported by said transport assembly, means sensing the position of at least one face of a board, and means responsive to said sensing means to move the associated element relative to said board as it is transported towards said material removing means by said transport assembly.

2. A bevelling machine according to Claim 1 wherein said sensing means includes a movable guide comprising a belt, and means urging at least a portion of said belt against one face of a board as it is transported by said transport assembly; and said moving means including a wedge slidably mounted on said transport assembly with said urging means located between said wedge and said belt; said means mounting said associated element including a member engaging said wedge so that variation in thickness of a board is sensed by said belt and transmitted to said wedge which via said member moves the mounting means and thereby said associated element towards or away from the board.

3. A bevelling machine according to Claim 2 including a fixed guide comprising a slipper, and a second belt trained over said slipper; said machine further including means securing said slipper and said block to said transport assembly to define a passageway between the first and second belts through which that portion of a board to be bevelled passes on being transported by said transport assembly.

4.   A bevelling machine according to Claim 1 wherein said sensing means includes air bearings mounted one each side of said path of travel, two blocks each having a bevelled surface and connected to a respective one of said air bearings, said moving means including ramps each engagable with the bevelled surface of a block.

5.   A bevelling machine comprising a pair of slides, means mounting said slides for linear movement towards and away from each other, a pair of grinding wheels each rotatably mounted on a respective slide, a pair of actuators each coupled to a respective slide to move the slides along said mounting means, a board transport assembly to move a board along a predetermined path of travel between and substantially at right angles to the linear movement of said slides and between said grinding wheels, sensing means mounted on said assembly to sense the thickness of said board as it is transported by said assembly along said path of travel, and means responsive to said sensing means to adjust the position of said slides on said mounting means relative to the centre line of said path of travel thereby maintaining a constant bevel produced on said board as it passes between said grinding wheels.

6.   A bevelling machine according to Claim 5 wherein said mounting means includes rails and said slides each include air bearings to float the slides along said rails.

7.   A bevelling machine according to Claim 5 wherein said board transport assembly includes two endless belts, a plurality of rollers about which said belts are trained to provide a straight run of each belt between which a board is gripped to be transported along said path of travel, and drive means for driving at least one of said belts.

8. A bevelling machine according to Claim 7 wherein said sensing means includes air bearings, one mounted on each side of said path of travel beneath said board transport assembly, and wherein said adjusting means comprises; a ramp mounted on each said slide, a bevelled edged block coupled to each said sensor and engaging a respective ramp, and means slidably mounting said blocks on said transport assembly, said blocks determining the position of said slides along said mounting means on actuation of said actuators and moving in sympathy with variations in thickness of a board to maintain said bevel produced by said grinding wheels constant.

9. A bevelling machine comprising a pair of slides, means mounting said slides for linear movement towards and away from each other, a pair of grinding wheels each rotatably mounted about an axis on a respective slide, a pair of actuators each coupled to a respective slide to move the slides along said mounting means, a board transport assembly to move a board along a predetermined path of travel between and substantially at right angles to the linear movement of said slides and between said grinding wheels, sensing means mounted on said assembly to sense the thickness of said board as it is transported by said assembly along said path of travel, said sensing means comprising a fixed guide and a movable guide mounted relative to said fixed guide to define a passageway therebetween through which that portion of the board to be bevelled is transported by said assembly, and means urging said movable guide towards said fixed guide; said machine further including means responsive to the movement of said movable guide as a board passes through said passageway to adjust the position of one slide on its mounting means to produce a predetermined depth of cut of the bevel on said board as it passes between said grinding wheels.

10. A bevelling machine according to Claim 9 wherein said mounting means includes rails and said slides each include air bearings to float the slides along said rails.

11. A bevelling machine according to Claim 10 wherein said board transport assembly includes two endless belts, a plurality of rollers about which said belts are trained to provide a straight run of each belt between which a board is gripped to be transported along said path of travel, and drive means for driving at least one of said belts.

12. A bevelling machine according to Claim 10 including switch means operable by a board as it is transported through said passageway to move said one slide to a predetermined position along its associated rail relative to the centre line of said path of travel as determined by the position of said movable guide to produce said predetermined depth of cut.

13. A bevelling machine according to Claim 12 wherein said switch means is adapted to cut off air to the air bearings in said one slide to clamp it to its associated rail at said predetermined position.

14. A bevelling machine according to Claim 9 wherein each actuator comprises a cylinder, a piston within said cylinder, a port for admitting compressed air into said cylinder and means to maintain constant the force exerted by said piston on its associated slide as the slide is moved by said piston along said mounting means.

15. A bevelling machine according to Claim 9 wherein each actuator comprises oppositely located end members, a bellows extending between and coupled to said members, a port for admitting compressed air into said bellows, means securing one end member to said mounting means, means coupling the other end member to its associated slide, and means to maintain constant the force exerted by said other end member on its associated slide as the slide is moved by said actuator along said mounting means.

16. A bevelling machine according to Claim 9 including means raising and lowering said transport assembly relative to the axes of said grinding wheels to adjust the angle of the bevel cut on a board transported along said predetermined path.

LLOYD WISE, TREGEAR & CO.
NORMAN HOUSE 105-109 STRAND
LONDON, WC2R 0AE

0028097

FIG.1A.

FIG.1C.

FIG.1B.

FIG.2.

0028097

FIG.3.

FIG.4.

FIG.5.

FIG.6.

0028097

**FIG.7.**

55
57
60
11
46C
59
4
61
47C  11  56
2
3

**FIG.10.**

90  91  3
7  92  93

**FIG.11.**

100  105  101  4
102
8
103
104

FIG.8.

FIG.9.

| | DOCUMENTS CONSIDERED TO BE RELEVANT | | CLASSIFICATION OF THE APPLICATION (Int. Cl.3) |
|---|---|---|---|
| Category | Citation of document with indication, where appropriate, of relevant passages | Relevant to claim | |
| | DE - U1 - 7 818 646 (R. EISENBLÄTTER) <br> * claims 1 to 7; fig. 2 * <br> -- | 1,7,11 | B 24 B 9/00 |
| | US - A - 3 238 675 (J.D. ABBOTT et al.) <br> * claims 1 and 2; column 1, line 69 <br>   to column 2, line 13 * <br> -- | 1 | |
| | GB - A - 1 480 667 (L. BOVONE) <br> * claim 1 * <br> -- | 1 | TECHNICAL FIELDS SEARCHED (Int. Cl.3) |
| P | DE - U1 - 8 004 412 (L.W. SYARTO et al.) <br> * claim 1 * <br> -- | 1,7 | B 23 C 3/12 <br> B 23 D 79/00 <br> B 24 B 3/48 <br> B 24 B 9/00 |
| A | US - A - 2 692 457 (W. BINDSZUS) <br> -- | | |
| A | GB - A - 1 489 044 (BANDO KIKO CO. <br>   LTD.) <br> -- | | |
| A | DE - A1 - 2 714 789 (BENNET TOOLS LTD.) <br> -- | | |
| A | US - A - 1 728 647 (K.A. WEBER) <br> ---- | | CATEGORY OF CITED DOCUMENTS |

X

The present search report has been drawn up for all claims

| Place of search | Date of completion of the search | Examiner |
|---|---|---|
| Berlin | 22-01-1981 | MARTIN |

EPO Form 1503.1  06.78